# EUROPÄISCHE PATENTSCHRIFT

(11) **EP 3 994 473 B1**
(45) Veröffentlichungstag und Bekanntmachung des Hinweises auf die Patenterteilung: **12.06.2024**
(21) Anmeldenummer: 20764027.7
(22) Anmeldetag: 17.08.2020
(51) Int. Cl.: G01R 31/12

(54) **AUSWERTEN VON TEILENTLADUNGSSIGNALEN**
EVALUATION OF PARTIAL DISCHARGE SIGNALS
ÉVALUATION DE SIGNAUX D'ÉVACUATION DE PIÈCES

(30) Priorität: 18.09.2019 EP 19198066
(43) Veröffentlichungstag der Anmeldung: 11.05.2022
(73) Patentinhaber: Innomotics GmbH, 90441 Nürnberg (DE)
(72) Erfinder: MEYER, Martin, 90425 Nürnberg (DE); SCHEIBNER, Dirk, 90473 Nürnberg (DE); ZETTNER, Jürgen, 90587 Veitsbronn (DE)
(74) Vertreter: Siemens Patent Attorneys
(86) Internationale Anmeldenummer: PCT/EP2020/072943
(87) Internationale Veröffentlichungsnummer: WO 2021/052691

(56) Entgegenhaltungen:
- EP-A1- 2 204 660
- EP-A2- 1 439 396
- DE-A1-102018 102 959
- BORGHETTO J ET AL: "Partial Discharge Inference by an Advanced System. Analysis of Online Measurements Performed on Hydrogenerator", IEEE TRANSACTIONS ON ENERGY CONVERSION, IEEE SERVICE CENTER, PISCATAWAY, NJ, US, Bd. 19, Nr. 2, 1. Juni 2004 (2004-06-01), Seiten 333-339, XP011113368, ISSN: 0885-8969, DOI: 10.1109/TEC.2004.827473

## Beschreibung

Die Erfindung betrifft das Auswerten von Teilentladungssignalen, die in der Nähe einer Isolierung der elektrischen Außenleiter eines Mehrphasenwechselstroms an nur einem Ort erfasst oder an mehreren Orten erfasst und einander überlagert werden. Mit anderen Worten betrifft die Erfindung ein "einkanaliges" Auswerten von Teilentladungssignalen, die nicht getrennt für die einzelnen Außenleiter des Mehrphasenwechselstroms erfasst und ausgewertet werden.

Teilentladungen sind lokale elektrische Entladungen, welche beispielsweise in lokalen Inhomogenitäten des Isolationsmaterials, beispielsweise in kleinen Lufteinschlüssen, innerhalb der Isolierung einer elektrischen Leitung infolge starker Inhomogenitäten eines elektrischen Feldes verursacht werden. Teilentladungen können eine Isolierung lokal beschädigen und langfristig zum Versagen der Isolierung führen. Deshalb werden insbesondere elektrische Maschinen regelmäßig auf Teilentladungen untersucht. Teilentladungen verursachen kurze elektromagnetische Pulse mit einer typischen Pulsdauer von weniger als 1 µs und Frequenzanteilen bis weit in den UHF-Frequenzbereich. Üblicherweise wird nach Teilentladungssignalen in Frequenzbereichen zwischen etwa 100 kHz und 10 MHz gesucht, in denen Teilentladungspulse in der Regel am stärksten sind.

Ein Außenleiter ist ein elektrischer Leiter, der im üblichen Betrieb unter elektrischer Spannung steht und zur Übertragung oder Verteilung elektrischer Energie beitragen kann, aber kein Neutralleiter (Mittelleiter) ist.

Für die Erfassung von Teilentladungen gibt es eine Vielzahl von teilweise, beispielsweise nach DIN EN 60270, genormten Messverfahren. An elektrischen Maschinen werden fast ausschließlich Offline-Messungen durchgeführt, bei denen der reguläre Betrieb einer elektrischen Maschine unterbrochen wird und hohe Kosten entstehen, beispielsweise durch die Betriebsunterbrechungen und die Kosten für die Messgeräte. Solche Messungen können deshalb nur gelegentlich durchgeführt werden.

Online-Messungen während des regulären Betriebs einer elektrischen Maschine ermöglichen ein kontinuierliches Überwachen der Maschine und insbesondere das Erkennen von Trends bezüglich Teilentladungsaktivitäten an der Maschine und eine Korrelation der Teilentladungsaktivitäten mit verschiedenen Umwelteinflüssen wie Temperatur, Luftfeuchte und Luftdruck. Die dadurch gewonnenen Informationen können eine zuverlässige Vorhersage ermöglichen, die den Zeitraum prognostiziert, in dem eine von Teilentladungen betroffene Maschine noch zuverlässig betrieben werden kann. Durch Messungen erfasste Teilentladungssignale werden typischerweise netzphasensynchron für Intervalle ihrer jeweiligen Energieinhalte als Teilentladungsrate in Form von Teilentladungshistogrammen aufgetragen und ausgewertet.

Im Falle eines aus mehreren Wechselströmen gebildeten Mehrphasenwechselstroms überlagern sich die Teilentladungen zeitlich, die von den verschiedenen Wechselströmen erzeugt werden. Deshalb werden in der Regel Teilentladungssignale für jeden dieser Wechselströme separat erfasst und ausgewertet. Will man aus Gründen der Kostenersparnis nur eine Teilentladungsmesseinheit beziehungsweise nur eine Auswerteeinheit verwenden, das heißt Teilentladungssignale an nur einem Ort erfassen oder an mehreren Orten erfasste, aber einander überlagerte Teilentladungssignale auswerten, so stellt sich das Problem, dass mit der herkömmlichen Auswertung von Teilentladungssignalen keine Aussagen mit Bezug auf die einzelnen Wechselströme möglich sind.

Aus der EP 2 204 660 A1 ist eine Vorrichtung und ein Verfahren zum Bestimmen von Teilentladungen an einer elektrischen Komponente bekannt. Bei dem Verfahren wird ein elektrisches Signal erfasst, welches Teilentladungsimpulse aufgrund der Teilentladungen der elektrischen Komponenten umfasst. Durch Filtern des elektrischen Signals mit n Filtern mit n unterschiedlichen Filtercharakteristiken werden n gefilterte Teilentladungssignale erzeugt. Jeweils eines der gefilterten Teilentladungssignale ist jeweils einem der n Filter zugeordnet, wobei n größer oder gleich zwei ist. Schließlich werden die Teilentladungen durch Verknüpfen der n gefilterten Teilentladungssignale bestimmt.

Aus der DE 102018102959 A1 ist eine Vorrichtung und ein Verfahren für eine Isolationsüberwachung mit Erkennung eines fehlerbehafteten Außenleiters in einem 3-phasigen ungeerdeten Stromversorgungssystem bekannt. Der Grundgedanke beruht hier darauf, ausgehend von nur einer Messung der Netzspannung gegen Erde an einem der Außenleiter und einer Messung der Sternpunktspannung gegen Erde, den Phasenwinkel zwischen der gemessenen Netzspannung und der gemessenen Sternpunktspannung zu bestimmen. Der Wert des so bestimmten Phasenwinkels liegt in einem von drei Winkelbereichen, die sich jeweils über 120 Grad erstrecken und einem der drei Außenleiter zuzuordnen sind, sodass der fehlerbehaftete Außenleiter bestimmt ist. Die Ermittlung des fehlerbehafteten Außenleiters erfolgt somit durch Messung von nur einer Netzspannung in Verbindung mit der Messung der Sternpunktspannung durch Auswertung der Phasenlage zwischen beiden gemessenen Spannungen.

Aus der EP 1439396 A2 ist ein Verfahren zur Analyse und Überwachung des Teilentladungsverhaltens eines elektrischen Betriebsmittels bekannt. Beschrieben wird ein Verfahren zur Analyse und/oder Überwachung des Teilentladungsverhaltens eines elektrischen Betriebsmittels, insbesondere in dessen zeitlicher Entwicklung. Dabei werden entsprechende Teilentladungsdaten in Prozesszustandsmatrixen festgehalten, in welchen jeweils in einem Matrixelement der Prozesszustandsmatrix die Amplitude einer Teilentladung, deren Phasenwinkel und deren Auftretenshäufigkeit abgebildet ist (insbesondere sog. PRPD-Darstellung). Eine vereinfachte Analyse wird dadurch ermöglicht, dass zu einem ersten Zeitpunkt ein Teilentladungsprozesszustand in einer ersten Prozesszustandsmatrix erfasst wird, und zu einem späteren Zeitpunkt ein weiterer Teilentladungsprozesszustand in einer weiteren Prozesszustandsmatrix erfasst wird. Anschließend werden zur Analyse und/oder Überwachung die erste und die zweite Prozesszustandsmatrix unter Zuhilfenahme von Vergleichs- und Normierungsverfahren verglichen.

Der Erfindung liegt die Aufgabe zugrunde, ein Verfahren zum verbesserten Auswerten von Teilentladungssignalen anzugeben, die in der Nähe einer Isolierung der elektrischen Außenleiter eines Mehrphasenwechselstroms an nur einem Ort erfasst oder an mehreren Orten erfasst und einander überlagert werden.

Die Aufgabe wird erfindungsgemäß durch ein Verfahren mit den Merkmalen des Anspruchs 1 gelöst.

Vorteilhafte Ausgestaltungen der Erfindung sind Gegenstand der abhängigen Ansprüche.

Bei dem erfindungsgemäßen Verfahren werden Teilentladungssignale ausgewertet, die in der Nähe einer Isolierung der elektrischen Außenleiter eines Mehrphasenwechselstroms, dessen in jeweils einem Außenleiter fließende Wechselströme feste Phasenverschiebungen gegeneinander aufweisen, an nur einem Ort erfasst oder an mehreren Orten erfasst und einander überlagert werden. Dazu wird wenigstens eine Kenngröße definiert, anhand derer Teilentladungssignale miteinander vergleichbar sind. Jedem Teilentladungssignal wird eine Phasenlage der Wechselströme zum Zeitpunkt der Erfassung des Teilentladungssignals zugeordnet. Für jedes Teilentladungssignal wird ein Kenngrößenwert jeder Kenngröße ermittelt. Jedem Teilentladungssignal wird ein Zahlentupel zugeordnet, das aus jedem Kenngrößenwert des Teilentladungssignals und der dem Teilentladungssignal zugeordneten Phasenlage gebildet wird. Es werden dann Cluster der Teilentladungssignale in einem mehrdimensionalen Raum mit von den Zahlentupeln gebildeten Punkten ermittelt, und aus den ermittelten Clustern wird für jeden Außenleiter eine Teilentladungsaktivität ermittelt.

In einer Ausgestaltung wird ein Teilentladungssignal über einen Anschluss zumindest eines Wicklungstemperatursensors ausgekoppelt. Mit der Auskopplung von einem oder einer Vielzahl von Teilentladungssignalen ergibt sich über einen Wicklungstemperatursensor bzw. über eine Vielzahl von Wicklungstemperatursensoren ein Teilentladungs-Erfassungsverfahren, das die Aktivität, also Teilentladungen, in allen Phasen überlagert misst. Um aus dieser Überlagerung die Aktivität der einzelnen Phasen zu separieren wird das Cluster, also ein Clusterverfahren verwendet. Das ist hilfreich, um die Aktivität einzelner Phasen verfolgen zu können und damit frühzeitig Änderungen in einer Phase zu erkennen, die in der Gesamtaktivität erst später erkennbar wären.

Das erfindungsgemäße Verfahren sieht also die Auswertung von Teilentladungssignalen in einem mehrdimensionalen Raum vor, dessen Koordinaten wenigstens eine Kenngröße der Teilentladungssignale und die Phasenlage der Wechselströme sind. In diesem Raum wird jedes Teilentladungssignal durch einen Punkt repräsentiert, der durch den wenigstens einen Kenngrößenwert des Teilentladungssignals und die Phasenlage zum Zeitpunkt der Erfassung des Teilentladungssignals bestimmt ist. Die die Teilentladungssignale repräsentierenden Punkte werden mit einer Clusteranalyse zu verschiedenen Clustern zusammenfasst, um die Teilentladungssignale den verschiedenen Außenleitern zuzuordnen beziehungsweise für jeden Außenleiter eine Teilentladungsaktivität zu ermitteln. Das erfindungsgemäße Verfahren ermöglicht damit eine phasen- beziehungsweise außenleiterabhängige Auswertung der Teilentladungssignale mit nur einer Messeinheit statt mit einer separaten Messeinheit für jeden Außenleiter und kann daher kostengünstig realisiert werden. Außerdem ermöglicht das erfindungsgemäße Verfahren, Teilentladungssignale online auszuwerten, beispielsweise im regulären Betrieb einer den Mehrphasenwechselstrom führenden elektrischen Maschine, da die Clusteranalyse keine speziellen Betriebsbedingungen erfordert.

Erfindungsgemäß wird eine Pulsdauer, Pulshöhe, elektrische Ladung, Energie und/oder Wiederholungsrate eines Teilentladungssignals als Kenngröße definiert. Beispielsweise bildet die Pulsdauer eine erste Kenngröße, die Pulshöhe bildet eine zweite Kenngröße usw.

Bei einer weiteren Ausgestaltung der Erfindung werden die Cluster mit einem partionierenden Clusterverfahren, einem hierarchischen Clusterverfahren, einem dichtebasierten Clusterverfahren und/oder mit Methoden neuronaler Netze ermittelt. Beispielsweise kann zum Clustering ein k-Means-Algorithmus, Mean Shift, Gaussian Mixture und/oder DBSCAN (density-based spatial clustering of applications with noise) verwendet werden.

Erfindungsgemäß wird für jedes Cluster ein Clusterschwerpunkt bestimmt und das Cluster wird einem Außenleiter zugeordnet, der aus der Phasenlage des Clusterschwerpunkts bestimmt wird. Beispielsweise wird jeder Phasenlage ein Außenleiter zugeordnet und ein Cluster wird demjenigen Außenleiter zugeordnet, der der Phasenlage des Clusterschwerpunkts des Clusters zugeordnet ist. Insbesondere kann vorgesehen sein, dass jeder Außenleiter wenigstens einem Phasenwinkelintervall von die Phasenlagen charakterisierenden Phasenwinkeln zugeordnet wird. Diese Ausgestaltung der Erfindung nutzt aus, dass Teilentladungen an einem Außenleiter sich in der Regel in bestimmten Phasenwinkelintervallen des in dem Außenleiter fließenden Wechselstroms häufen, beispielsweise in Phasenwinkelintervallen, in denen der Wechselstrom oder die korrespondierende Wechselspannung eine relativ starke Steigung aufweist. Da die Wechselströme der einzelnen Außenleiter feste Phasenverschiebungen gegeneinander aufweisen, können daher Phasenwinkelintervalle von die Phasenlagen der Wechselströme charakterisierenden Phasenwinkeln jeweils einem der Außenleiter zugeordnet werden, an dem in dem jeweiligen Phasenwinkelintervall eine erhöhte Wahrscheinlichkeit für Teilentladungen vorliegt.

Bei einer weiteren Ausgestaltung der Erfindung wird zur Ermittlung der Teilentladungsaktivität eines Außenleiters wenigstens eine Aktivitätsgröße für Teilentladungssignale definiert, die in einem vorgegebenen Zeitfenster erfasst werden und dem Außenleiter zugeordnet werden. Als eine Aktivitätsgröße wird beispielsweise eine Anzahl von Teilentladungssignalen definiert, die in dem Zeitfenster erfasst werden und dem Außenleiter zugeordnet werden. Alternativ oder zusätzlich wird eine Aktivitätsgröße aus den Kenngrößenwerten der Teilentladungssignale gebildet, die in dem Zeitfenster erfasst werden und dem Außenleiter zugeordnet werden. Dies ermöglicht eine quantitative Bewertung und Auswertung der Teilentladungsaktivität an jedem Außenleiter.

Bei einer Weitergestaltung der vorgenannten Ausgestaltung der Erfindung wird eine zeitliche Verteilung der Aktivitätswerte wenigstens einer Aktivitätsgröße jedes Außenleiters erfasst und ausgewertet. Dabei kann vorgesehen sein, dass für jede zeitliche Verteilung von Aktivitätswerten eine Anomalieerkennung durchgeführt wird, mit der anomale Aktivitätswerte ermittelt werden, und anomale Aktivitätswerte aus der jeweiligen Verteilung der Aktivitätswerte entfernt werden. Ferner kann vorgesehen sind, dass für wenigstens eine Aktivitätsgrö-ße und jeden Außenleiter aus der zeitlichen Verteilung der Aktivitätswerte eine Regressionskurve für einen Verlauf der Aktivitätsgröße in Abhängigkeit von der Zeit ermittelt wird. Zusätzlich kann vorgesehen sein, dass eine erste Ableitung jeder Regressionskurve nach der Zeit ermittelt wird. Durch derartige Auswertungen der zeitlichen Verteilungen von Aktivitätswerte der einzelnen Außenleiter können vorteilhaft Trends der Teilentladungsaktivitäten an jedem Außenleiter erkannt werden und Prognosen der zukünftigen Entwicklung dieser Teilentladungsaktivitäten hergeleitet werden. Ferner können beispielsweise Warn- und/oder Alarmsignale erzeugt werden, wenn eine Regressionskurve einen vorgegebenen Schwellenwert überschreitet oder die Ableitung einer Regressionskurve einen vorgegebenen Schwellenwert überschreitet.

Eine erfindungsgemäße Auswerteeinheit zum Auswerten von Teilentladungssignalen gemäß dem erfindungsgemäßen Verfahren ist eingerichtet, jedem Teilentladungssignal die Phasenlage der Wechselströme zum Zeitpunkt der Erfassung des Teilentladungssignals zuzuordnen, für jedes Teilentladungssignal den Kenngrößenwert jeder Kenngröße zu ermitteln, jedem Teilentladungssignal das Zahlentupel zuzuordnen, das aus jedem Kenngrößenwert des Teilentladungssignals und der dem Teilentladungssignal zugeordneten Phasenlage gebildet wird, die Cluster der Teilentladungssignale in dem mehrdimensionalen Raum mit von den Zahlentupeln gebildeten Punkten zu ermitteln und aus den ermittelten Clustern für jeden Außenleiter die Teilentladungsaktivität zu ermitteln.

Insbesondere kann die Auswerteeinheit dazu eingerichtet sein, ein erfindungsgemäßes Computerprogramm auszuführen. Ein erfindungsgemäßes Computerprogramm umfasst Befehle, die bei der Ausführung des Computerprogramms durch eine Auswerteeinheit diese veranlassen, das erfindungsgemäße Verfahren auszuführen.

Dadurch kann das erfindungsgemäße Verfahren mit den oben genannten Vorteilen, insbesondere computerimplementiert, realisiert werden.

Alternativ kann das Verfahren in wenigstens einem so genannten Edge Device oder in einer Applikation in einer Rechnerwolke (Cloud) ausgeführt oder teilausgeführt werden.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
FIG 1 ein Ablaufdiagramm eines Ausführungsbeispiels eines erfindungsgemäßen Verfahrens zum Auswerten von Teilentladungssignalen,
FIG 2 Cluster von Teilentladungssignalen und Clusterschwerpunkte,
FIG 3 eine zeitliche Verteilung von Aktivitätswerten einer Aktivitätsgröße für eine Teilentladungsaktivität und eine Regressionskurve für einen zeitlichen Verlauf der Aktivitätsgröße,
FIG 4 Regressionskurven für zeitliche Verläufe einer Akti-vitätsgröße für die Außenleiter eines Dreiphasenwechselstroms.

Einander entsprechende Teile sind in den Figuren mit denselben Bezugszeichen versehen.

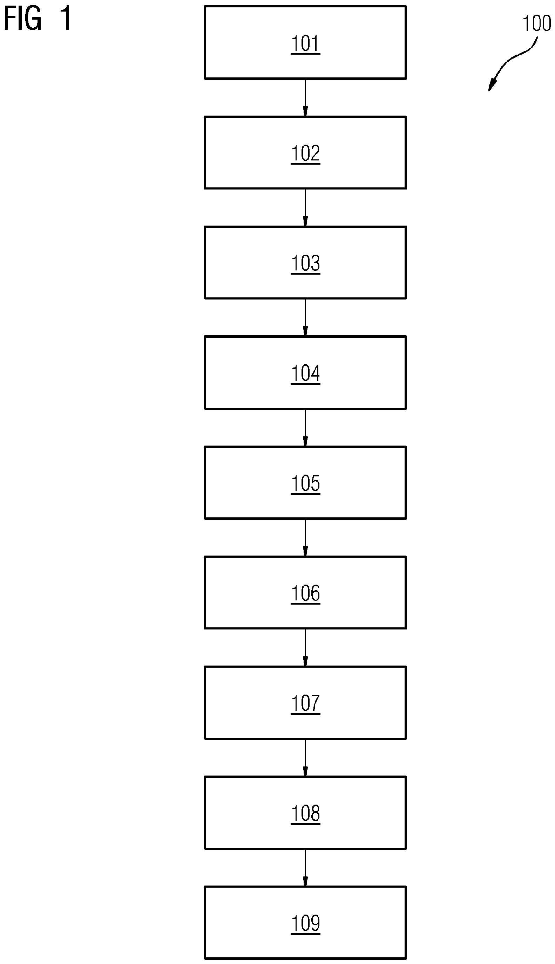

FIG 1 zeigt ein Ablaufdiagramm 100 eines Ausführungsbeispiels eines erfindungsgemäßen Verfahrens mit Verfahrensschritten 101 bis 109 zum Auswerten von Teilentladungssignalen, die in der Nähe einer Isolierung der elektrischen Außenleiter eines Mehrphasenwechselstroms, dessen in jeweils einem Außenleiter fließende Wechselströme feste Phasenverschiebungen gegeneinander aufweisen, an nur einem Ort erfasst oder an mehreren Orten erfasst und einander überlagert werden. Die Teilentladungssignale werden beispielsweise mit einer Antenne erfasst und mit einem Frequenzfilter gefiltert, dessen Durchlassbereich für Teilentladungssignale typische Frequenzen aufweist. Es kann aber auch ein beliebiger anderer Sensor zum Erfassen der Teilentladungssignale verwendet werden, beispielsweise eine kapazitive Sensorvorrichtung mit mindestens einem Sensorkondensator oder eine induktive Kopplungsvorrichtung mit mindestens einer Sensorspule. Dies ist für die Erfindung unerheblich.

In einem ersten Verfahrensschritt 101 wird wenigstens eine Kenngröße K definiert, anhand derer Teilentladungssignale miteinander vergleichbar sind. Eine derartige Kenngröße kann beispielsweise eine Pulsdauer, Pulshöhe, elektrische Ladung, Energie oder Wiederholungsrate eines Teilentladungssignals sein.

In einen zweiten Verfahrensschritt 102 wird jedem Teilentladungssignal eine Phasenlage der Wechselströme zum Zeitpunkt der Erfassung des Teilentladungssignals zugeordnet. Die Phasenlage wird durch einen Phasenwinkel ϕ eines der Wechselströme definiert.

In einem dritten Verfahrensschritt 103 wird für jedes Teilentladungssignal ein Kenngrößenwert jeder Kenngröße K ermittelt.

In einem vierten Verfahrensschritt 104 wird jedem Teilentladungssignal ein Zahlentupel zugeordnet, das aus jedem Kenngrößenwert des Teilentladungssignals und der dem Teilentladungssignal zugeordneten Phasenlage gebildet wird. Wenn beispielsweise die Kenngrößen K eine Pulsdauer und Pulshöhe sind, sind die Einträge des einem Teilentladungssignal zugeordneten Zahlentupels der Kenngrößenwert der Pulsdauer, der Kenngrößenwert der Pulshöhe und die dem Teilentladungssignal zugeordnete Phasenlage.

In einem fünften Verfahrensschritt 105 werden jeweils für ein vorgegebenes Zeitfenster Cluster C der in diesem Zeitfenster erfassten Teilentladungssignale in einem mehrdimensionalen Raum S mit von den Zahlentupeln gebildeten Punkten V ermittelt. Die Cluster C werden beispielsweise mit einem partionierenden Clusterverfahren (z.B. basierend auf einem k-Means-Algorithmus), einem hierarchischen Clusterverfahren, einem dichtebasierten Clusterverfahren (z.B. DBSCAN) und/oder mit Methoden neuronaler Netze ermittelt.

In einem sechsten Verfahrensschritt 106 wird jedem Cluster C ein Außenleiter zugeordnet. Dazu wird jeder Außenleiter wenigstens einem Phasenwinkelintervall I1 bis I6 zugeordnet, für jedes Cluster C wird ein Clusterschwerpunkt P bestimmt und ein Cluster C wird demjenigen Außenleiter zugeordnet, der der Phasenlage des Clusterschwerpunkts P des Clusters C (das heißt dem Wert der Koordinate ϕ des Clusterschwerpunkts P in dem Raum S) zugeordnet ist.

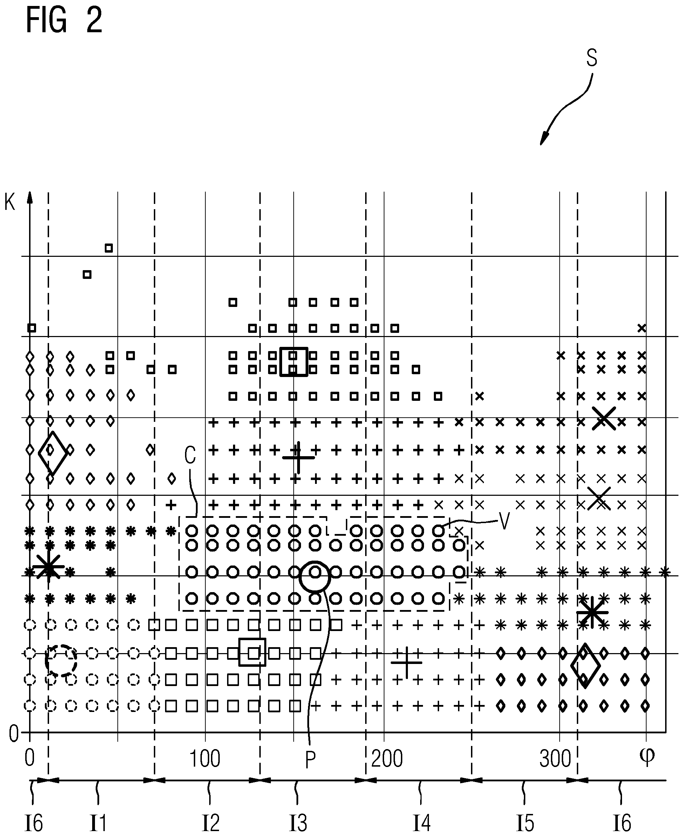

FIG 2 zeigt beispielhaft für einen Dreiphasenwechselstrom mit um 120° gegeneinander phasenverschobenen Wechselströmen in einem Zeitfenster ermittelte Cluster C und deren Clusterschwerpunkte P, wobei die einem Cluster C zugehörigen Punk-te V durch gleiche und von anderen Clustern C verschiedene Symbole dargestellt sind. Einem ersten Außenleiter sind die Phasenwinkelintervalle I1 und I4 zugeordnet. Einem zweiten Außenleiter sind die Phasenwinkelintervalle I2 und I5 zugeordnet. Dem dritten Außenleiter sind die Phasenwinkelintervalle I3 und I6 zugeordnet. Jedes Phasenwinkelintervall I1 bis I6 hat eine Breite von 60°. Die Phasenwinkelintervalle I1 und I3 weisen jeweils drei Clusterschwerpunkte P auf. Die Phasenwinkelintervall I2 und I4 weisen jeweils einen Clusterschwerpunkt P auf. Das Phasenwinkelintervall I5 weist keinen Clusterschwerpunkt P auf. Das Phasenwinkelintervall I6 weist vier Clusterschwerpunkte P auf. Somit werden dem ersten Außenleiter in dem Zeitfenster insgesamt vier Clusterschwerpunkte P zugeordnet, dem zweiten Außenleiter wird ein Clusterschwerpunkt P zugeordnet, und dem dritten Außenleiter werden sieben Clusterschwerpunkte P zugeordnet.

In einem siebten Verfahrensschritt 107 wird aus den ermittelten Clustern C für jeden Außenleiter eine Teilentladungsaktivität in jedem Zeitfenster ermittelt. Dazu wird wenigstens eine Aktivitätsgröße A für Teilentladungssignale definiert, die in dem jeweiligen Zeitfenster erfasst werden und einem Außenleiter zugeordnet werden. Als eine Aktivitätsgröße A wird beispielsweise eine Anzahl von Teilentladungssignalen definiert, die in dem Zeitfenster erfasst werden und dem Außenleiter zugeordnet werden. Alternativ oder zusätzlich wird eine Aktivitätsgröße A aus den Kenngrößenwerten der Teilentladungssignale gebildet, die in dem Zeitfenster erfasst werden und dem Außenleiter zugeordnet werden. Beispielsweise wird als eine Aktivitätsgröße A der Wert einer Kenngröße K des Clusterschwerpunkts P verwendet, und/oder eine Aktivitätsgröße A wird aus Maxima, Minima, Standardabweichungen, Verhältnissen von Maxima zu Mittelwerten und/oder statistischen Momenten der Kenngrößenwerte der zu einem Cluster C gehörigen Teilentladungssignale gebildet.

In einem achten Verfahrensschritt 108 wird eine zeitliche Verteilung der Aktivitätswerte wenigstens einer Aktivitätsgröße A jedes Außenleiters erfasst, beispielsweise eine Verteilung über mehrere Monate. Ferner wird für jede dieser zeitlichen Verteilungen eine Anomalieerkennung (engl. anomaly detection, auch als outlier detection bezeichnet) durchgeführt, mit der so genannte anomale Aktivitätswerte ermittelt werden, und anomale Aktivitätswerte werden aus der jeweiligen Verteilung der Aktivitätswerte entfernt. Zur Anomalieerkennung wird eine zeitliche Verteilung der Aktivitätswerte beispielsweise mit einem dichtebasierten Clusterverfahren wie DBSCAN analysiert. Eine derartige Anomalieerkennung ist beispielsweise aus M. M. Breunig et al., LOF: identifying density-based local outliers, Proceedings of the 2000 ACM SIGMOD international conference on Management of data, S. 93-104, doi: 10.1145/342009.335388 bekannt.

In einem neunten Verfahrensschritt 109 wird für wenigstens eine Aktivitätsgröße A und jeden Außenleiter aus der zeitlichen Verteilung der Aktivitätswerte eine Regressionskurve R, R1 bis R3 für einen Verlauf der Aktivitätsgröße A in Abhängigkeit von der Zeit t ermittelt, beispielsweise mit bekannten Methoden der so genannten Support Vector Machine Regression. Ferner kann vorgesehen sein, eine erste Ableitung jeder Regressionskurve R, R1 bis R3 nach der Zeit zu ermitteln. Anhand der Regressionskurven R, R1 bis R3 sowie gegebenenfalls deren erster Ableitungen wird die zeitliche Entwicklung der Teilentladungsaktivitäten jedes Außenleiters überwacht. Beispielsweise wird automatisch ein Warn- und/oder Alarmsignal erzeugt, wenn eine Regressionskurve R, R1 bis R3 einen vorgegebenen Schwellenwert oder die erste Ableitung einer Regressionskurve R, R1 bis R3 einen vorgegebenen Schwellenwert überschreitet.

Das anhand der Verfahrensschritte 101 bis 109 beschriebene Verfahren kann beispielsweise dahingehend erweitert werden, dass vor der Ermittlung der Cluster C in dem vierten Verfahrensschritt 104 eine Anomalieerkennung in dem mehrdimensionalen Raum S durchgeführt wird, um anomale Teilentladungssignale zu eliminieren.

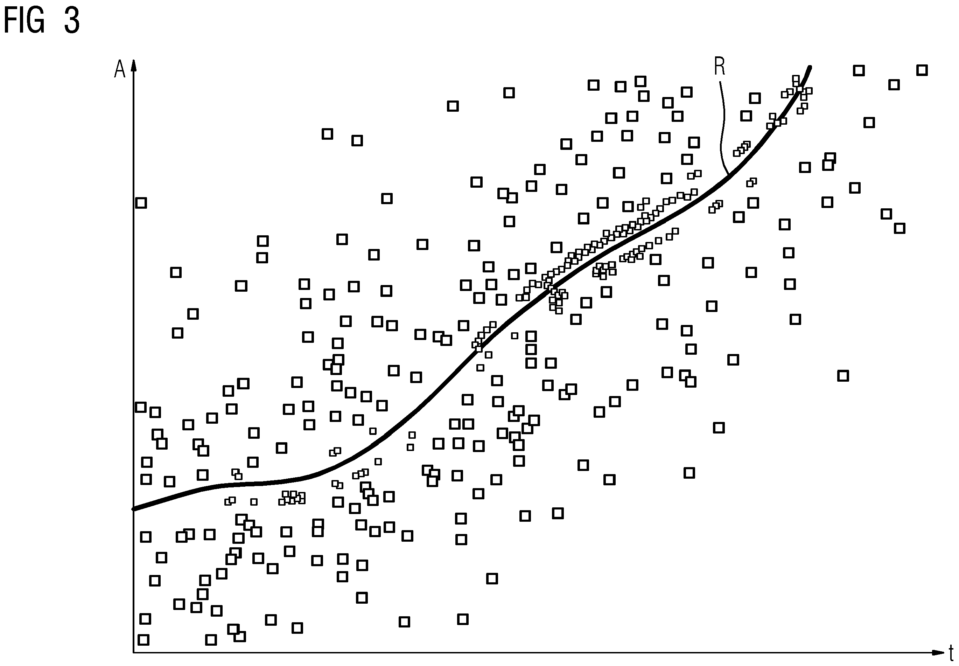

FIG 3 zeigt beispielhaft eine zeitliche Verteilung von Aktivitätswerten einer Aktivitätsgröße A für einen Außenleiter und eine Regressionskurve R für den Verlauf der Aktivitätsgröße A in Abhängigkeit von der Zeit t. Anomale Aktivitätswerte liegen weiter von der Regressionskurve R entfernt und sind mit einem anderen Symbol dargestellt als die anderen Aktivitätswerte A.

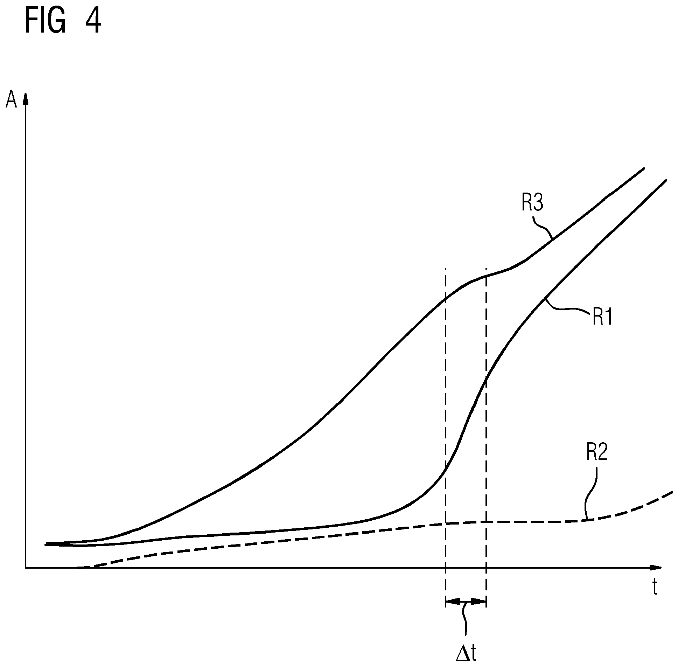

FIG 4 zeigt beispielhaft Regressionskurven R1 bis R3 für zeitliche Verläufe einer Aktivitätsgröße A für die drei Außenleiter eines Dreiphasenwechselstroms. Die Regressionskurve R1 eines ersten Außenleiters verläuft oberhalb der Regressionskurve R2 eines zweiten Außenleiters und unterhalb der Regressionskurve R3 des dritten Außenleiters, weist jedoch in einem Zeitintervall Δt hohe Steigungen auf. Daraus wird beispielsweise gefolgert, dass an dem dritten Außenleiter die höchste Teilentladungsaktivität auftritt, an dem zweiten Außenleiter die geringste Teilentladungsaktivität auftritt und die Teilentladungsaktivität an dem ersten Außenleiter in dem Zeitintervall Δt sehr schnell zunimmt.

Die Verfahrensschritte 101 bis 109 werden beispielsweise durch eine Auswerteeinheit zum Auswerten von Teilentladungssignalen durchgeführt, auf der ein Computerprogramm ausgeführt wird, das Befehle umfasst, die bei der Ausführung des Computerprogramms durch die Auswerteeinheit diese veranlassen, die Verfahrensschritte 101 bis 109 auszuführen. Insbesondere kann die Auswerteeinheit wenigstens einen so genannten neuromorphen integrierten Schaltkreis aufweisen. Alternativ wird das Verfahren in wenigstens einem so genannten Edge Device oder in einer Applikation in einer Rechnerwolke (Cloud) ausgeführt oder teilausgeführt.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Verfahren zum Auswerten von Teilentladungssignalen, die in der Nähe einer Isolierung der elektrischen Außenleiter eines Mehrphasenwechselstroms, dessen in jeweils einem Außenleiter fließende Wechselströme feste Phasenverschiebungen gegeneinander aufweisen, an nur einem Ort erfasst oder an mehreren Orten erfasst und einander überlagert werden, wobei
- wenigstens eine Kenngröße (K) definiert wird, anhand derer Teilentladungssignale miteinander vergleichbar sind,
- jedem Teilentladungssignal eine Phasenlage der Wechselströme zum Zeitpunkt der Erfassung des Teilentladungssignals zugeordnet wird,
- für jedes Teilentladungssignal ein Kenngrößenwert jeder Kenngröße (K) ermittelt wird,
- jedem Teilentladungssignal ein Zahlentupel zugeordnet wird, das aus jedem Kenngrößenwert des Teilentladungssignals und der dem Teilentladungssignal zugeordneten Phasenlage gebildet wird,
- Cluster (C) der Teilentladungssignale in einem mehrdimensionalen Raum (S) mit von den Zahlentupeln gebildeten Punkten (V) ermittelt werden **dadurch gekennzeichnet, dass**
- aus den ermittelten Clustern (C) für jeden Außenleiter eine Teilentladungsaktivität ermittelt wird, wobei eine Pulsdauer, Pulshöhe, elektrische Ladung, Energie und/oder Wiederholungsrate eines Teilentladungssignals als Kenngröße (K) definiert wird, wobei für jedes Cluster (C) ein Clusterschwerpunkt (P) bestimmt wird und das Cluster (C) einem Außenleiter zugeordnet wird, der aus der Phasenlage des Clusterschwerpunkts (P) bestimmt wird, wobei durch eine Auswertungen der zeitlichen Verteilungen von Aktivitätswerten der einzelnen Außenleiter Trends der Teilentladungsaktivitäten an jedem Außenleiter erkannt werden.

2. Verfahren nach Anspruch 1, wobei Prognosen der zukünftigen Entwicklung dieser Teilentladungsaktivitäten hergeleitet werden.

3. Verfahren nach Anspruch 1 oder 2, wobei die Cluster (C) mit einem partionierenden Clusterverfahren, einem hierarchischen Clusterverfahren, einem dichtebasierten Clusterverfahren und/oder mit Methoden neuronaler Netze ermittelt werden.

4. Verfahren nach einem der Ansprüche 1 bis 3, wobei jeder Phasenlage ein Außenleiter zugeordnet wird und ein Cluster (C) demjenigen Außenleiter zugeordnet wird, der der Phasenlage des Clusterschwerpunkts (P) des Clusters (C) zugeordnet ist.

5. Verfahren nach Anspruch 4, wobei jeder Außenleiter wenigstens einem Phasenwinkelintervall (I1 bis I6) von die Phasenlagen charakterisierenden Phasenwinkeln (ϕ) zugeordnet wird.

6. Verfahren nach einem der vorhergehenden Ansprüche, wobei zur Ermittlung der Teilentladungsaktivität eines Außenleiters wenigstens eine Aktivitätsgröße (A) für Teilentladungssignale definiert wird, die in einem vorgegebenen Zeitfenster erfasst werden und dem Außenleiter zugeordnet werden.

7. Verfahren nach Anspruch 6, wobei als eine Aktivitätsgröße (A) eine Anzahl von Teilentladungssignalen definiert wird, die in dem Zeitfenster erfasst werden und dem Außenleiter zugeordnet werden.

8. Verfahren nach Anspruch 6 oder 7, wobei eine Aktivitätsgröße (A) aus den Kenngrößenwerten der Teilentladungssignale gebildet wird, die in dem Zeitfenster erfasst werden und dem Außenleiter zugeordnet werden.

9. Verfahren nach einem der Ansprüche 6 bis 8, wobei eine zeitliche Verteilung der Aktivitätswerte wenigstens einer Aktivitätsgröße (A) jedes Außenleiters erfasst und ausgewertet wird.

10. Verfahren nach Anspruch 9, wobei für jede zeitliche Verteilung von Aktivitätswerten eine Anomalieerkennung durchgeführt wird, mit der anomale Aktivitätswerte ermittelt werden, und anomale Aktivitätswerte aus der jeweiligen Verteilung der Aktivitätswerte entfernt werden.

11. Verfahren nach Anspruch 9 oder 10, wobei für wenigstens eine Aktivitätsgröße (A) und jeden Außenleiter aus der zeitlichen Verteilung der Aktivitätswerte eine Regressionskurve (R, R1, bis R3) für einen Verlauf der Aktivitätsgröße (A) in Abhängigkeit von der Zeit (t) ermittelt wird.

12. Verfahren nach Anspruch 11, wobei eine erste Ableitung jeder Regressionskurve (R, R1, bis R3) nach der Zeit (t) ermittelt wird.

13. Auswerteeinheit zum Auswerten von Teilentladungssignalen gemäß dem Verfahren nach einem der vorhergehenden Ansprüche, wobei die Auswerteeinheit eingerichtet ist,
- jedem Teilentladungssignal die Phasenlage der Wechselströme zum Zeitpunkt der Erfassung des Teilentladungssignals zuzuordnen,
- für jedes Teilentladungssignal den Kenngrößenwert jeder Kenngröße (K) zu ermitteln,
- jedem Teilentladungssignal das Zahlentupel zuzuordnen, das aus jedem Kenngrößenwert des Teilentladungssignals und der dem Teilentladungssignal zugeordneten Phasenlage gebildet wird,
- die Cluster (C) der Teilentladungssignale in dem mehrdimensionalen Raum (S) mit von den Zahlentupeln gebildeten Punkten (V) zu ermitteln und
- aus den ermittelten Clustern (C) für jeden Außenleiter die Teilentladungsaktivität zu ermitteln.

14. Computerprogramm, umfassend Befehle, die bei der Ausführung des Computerprogramms durch eine Auswerteeinheit diese veranlassen, das Verfahren nach einem der Ansprüche 1 bis 12 auszuführen.

## Claims

1. Method for the evaluation of partial discharge signals which, in the vicinity of an insulation of the electrical line conductor of a multiphase alternating current, of which the alternating currents flowing in one line conductor in each case have fixed phase shifts in relation to one another, are detected at only one location or are detected at multiple locations and overlaid on one another, wherein
- at least one characteristic variable (K) is defined, on the basis of which partial discharge signals can be compared with one another,
- each partial discharge signal is assigned a phase position of the alternating currents at the point in time of the detection of the partial discharge signal,
- a characteristic variable value of each characteristic variable (K) is ascertained for each partial discharge signal,
- each partial discharge signal is assigned a numerical tuple that is formed of each characteristic variable value of the partial discharge signal and the phase position assigned to the partial discharge signal,
- clusters (C) of the partial discharge signals are ascertained in a multidimensional space (S) with points (V) formed by the numerical tuples, **characterised in that**
- a partial discharge activity is ascertained from the ascertained clusters (C) for each line conductor, wherein a pulse duration, pulse height, electric charge, energy and/or repetition rate of a partial discharge signal is defined as characteristic variable (K), wherein a cluster centroid (P) is determined for each cluster (C) and the cluster (C) is assigned to a line conductor that is determined from the phase position of the cluster centroid (P), wherein trends of the partial discharge activities on any line conductor are identified through evaluations of the temporal distributions of activity values of the individual line conductors.

2. Method according to claim 1, wherein predictions of the future development of said partial discharge activities are deduced.

3. Method according to claim 1 or 2, wherein the clusters (C) are ascertained using a partitioning cluster method, a hierarchical cluster method, a density-based cluster method and/or using neural network methods.

4. Method according to one of claims 1 to 3, wherein each phase position is assigned a line conductor and a cluster (C) is assigned to the line conductor that is assigned to the phase position of the cluster centroid (P) of the cluster (C).

5. Method according to claim 4, wherein each line conductor is assigned to at least one phase angle interval (I1 to I6) of phase angles (ϕ) that characterise the phase positions.

6. Method according to one of the preceding claims, wherein to ascertain the partial discharge activity of a line conductor, at least one activity variable (A) is defined for partial discharge signals that are detected in a predefined time window and assigned to the line conductor.

7. Method according to claim 6, wherein a number of partial discharge signals, which are detected in the time window and assigned to the line conductor, are defined as an activity variable (A).

8. Method according to claim 6 or 7, wherein an activity variable (A) is formed from the characteristic variable values of the partial discharge signals which are detected in the time window and assigned to the line conductor.

9. Method according to one of claims 6 to 8, wherein a temporal distribution of the activity values of at least one activity variable (A) of each line conductor is detected and evaluated.

10. Method according to claim 9, wherein for each temporal distribution of activity values an anomaly detection is performed, with which anomalous activity values are ascertained, and anomalous activity values are removed from the respective distribution of the activity values.

11. Method according to claim 9 or 10, wherein for at least one activity variable (A) and each line conductor, a regression curve (R, R1 to R3) for a progression of the activity variable (A) as a function of time (t) is ascertained from the temporal distribution of the activity values.

12. Method according to claim 11, wherein a first derivation of each regression curve (R, R1 to R3) with respect to time (t) is ascertained.

13. Evaluation unit for the evaluation of partial discharge signals according to the method according to one of the preceding claims, wherein the evaluation unit is configured
- to assign each partial discharge signal the phase position of the alternating currents at the point in time of the detection of the partial discharge signal,
- to ascertain the characteristic variable value of each characteristic variable (K) for each partial discharge signal,
- to assign each partial discharge signal the numerical tuple that is formed of each characteristic variable value of the partial discharge signal and the phase position assigned to the partial discharge signal,
- to ascertain the clusters (C) of the partial discharge signals in the multidimensional space (S) with points (V) formed by the numerical tuples and
- to ascertain the partial discharge activity from the ascertained clusters (C) for each line conductor.

14. Computer program, comprising commands which, when the computer program is executed by an evaluation unit, prompt it to carry out the method according to one of claims 1 to 12.

## Revendications

1. Procédé d'évaluation de signaux de décharge partielle, que l'on détecte en seulement un endroit ou en plusieurs endroits, et que l'on superpose les uns aux autres à proximité d'une isolation des conducteurs électriques extérieurs d'un courant alternatif polyphasé, dont les courants alternatifs passant dans respectivement un conducteur extérieur ont des déphasages fixes les uns par rapport aux autres, dans lequel
- on définit au moins une grandeur (K) caractéristique à l'aide de laquelle des signaux de décharge partielle sont comparables les uns aux autres,
- on affecte à chaque signal de décharge partielle une position en phase des courants alternatifs, à l'instant de la détection du signal de décharge partielle,
- on détermine pour chaque signal de décharge partielle une valeur de grandeur caractéristique de chaque grandeur (K) caractéristique,
- on affecte à chaque signal de décharge partielle un tuple numérique, que l'on forme à partir de chaque valeur de grandeur caractéristique du signal de décharge partielle et de la position en phase affectée au signal de décharge partielle,
- on détermine des grappes (C) des signaux de décharge partielle dans un espace (S) à plusieurs dimensions par des points (V) formés par les tuples numériques, **caractérisé en ce que**
- à partir des grappes (C) déterminées, on détermine pour chaque conducteur extérieur une activité de décharge partielle, dans lequel on définit une durée d'impulsion, une amplitude d'impulsion, une charge électrique, de l'énergie ou un taux de répétition d'un signal de décharge partielle comme grandeur (K) caractéristique, dans lequel on détermine pour chaque grappe (C) un centre (P) de gravité de grappe et on affecte la grappe (C) à un conducteur extérieur, que l'on détermine à partir de la position en phase du centre (P) de gravité de grappe, dans lequel par une évaluation des répartitions dans le temps de valeurs d'activité des divers conducteurs extérieurs, on détecte des tendances des activités de décharge partielle sur chaque conducteur extérieur.

2. Procédé suivant la revendication 1, dans lequel on d'éduit des prévisions du développement à venir de ces activités de décharge partielle.

3. Procédé suivant la revendication 1 ou 2, dans lequel on détermine les grappes (C) par un procédé de grappe de partitionnement, un procédé de grappe hiérarchique, un procédé reposant sur la densité et/ou par des méthodes de réseaux neuronaux.

4. Procédé suivant l'une des revendications 1 à 3, dans lequel on affecte un conducteur extérieur à chaque position en phase et on affecte une grappe (C) au conducteur extérieur, qui est affecté à la position en phase du centre (P) de gravité de grappe de la grappe (C).

5. Procédé suivant la revendication 4, dans lequel on affecte à chaque conducteur extérieur au moins un intervalle (I1 à I6) d'angle de phase, d'angles (ϕ) de phase caractérisant les positions en phase.

6. Procédé suivant l'une des revendications précédentes, dans lequel, pour la détermination de l'activité de décharge partielle d'un conducteur extérieur, on définit au moins une grandeur (A) d'activité de signaux de décharge partielle, que l'on détecte dans un créneau temporel donné à l'avance et que l'on affecte au conducteur extérieur.

7. Procédé suivant la revendication 6, dans lequel on définit, comme grandeur (A) d'activité, un nombre de signaux de décharge partielle, que l'on détecte dans le créneau temporel et que l'on affecte au conducteur partiel.

8. Procédé suivant la revendication 6 ou 7, dans lequel on forme une grandeur (A) d'activité à partir des valeurs de grandeurs caractéristiques des signaux de décharge partielle, que l'on détecte dans le créneau temporel et que l'on affecte au conducteur extérieur.

9. Procédé suivant l'une des revendications 6 à 8, dans lequel on détecte et on évalue une répartition dans le temps des valeurs d'activité d'au moins une grandeur (A) d'activité de chaque conducteur extérieur.

10. Procédé suivant la revendication 9, dans lequel pour chaque répartition dans le temps de valeurs d'activité, on effectue une détection d'anomalie, par laquelle on détermine des valeurs d'activité anormales et on élimine des valeurs d'activité anormales de la répartition respective des valeurs d'activité.

11. Procédé suivant la revendication 9 ou 10, dans lequel pour au moins une grandeur (A) d'activité et chaque conducteur extérieur, on détermine à partir de la répartition dans le temps des valeurs d'activité, une courbe (R, R1, à R3) de régression pour une variation de la grandeur (A) d'activité en fonction du temps (t).

12. Procédé suivant la revendication 11, dans lequel on détermine une première dérivée de chaque courbe (R, R1, à R3) de régression en fonction du temps (t).

13. Unité d'évaluation pour l'évaluation de signaux de décharge partielle selon le procédé suivant l'une des revendications précédentes, dans laquelle l'unité d'évaluation est agencée,
- pour affecter à chaque signal de décharge partielle la position en phase des courants alternatifs, à l'instant de la détection du signal de décharge partielle,
- pour chaque décharge partielle, pour déterminer la valeur de grandeur caractéristique de chaque grandeur (K) caractéristique,
- pour affecter à chaque signal de décharge partielle le tuple numérique, que l'on forme à partir de chaque valeur de grandeur caractéristique du signal de décharge partielle et de la position en phases affectée au signal de décharge partielle,
- pour déterminer les grappes (C) des signaux de décharge partielle dans l'espace (S) à plusieurs dimensions par les points (V) formés par les tuples numériques et
- pour déterminer à partir des grappes (C) déterminées pour chaque conducteur extérieur l'activité de décharge partielle.

14. Programme d'ordinateur comprenant des instructions, qui, lors de l'exécution du programme d'ordinateur par une unité d'évaluation, font que celles-ci exécutent le procédé suivant l'une des revendications 1 à 12.
